# EUROPEAN PATENT APPLICATION

(11) **EP 4 645 635 A1**
(43) Date of publication of application: **05.11.2025**
(21) Application number: 24305669.4
(22) Date of filing: 29.04.2024
(51) Int. Cl.: H02J 7/00, H01M 10/42, G01R 31/3835, G01R 31/396

(54) **A DRIVER CIRCUIT AND METHOD FOR A BATTERY MANAGEMENT SYSTEM**

(71) Applicant: NXP USA, Inc., Austin TX 78735 (US)
(72) Inventor: Tico, Olivier, 31023 Toulouse (FR); Abouda, Pascal Kamel, 31023 Toulouse (FR)
(74) Representative: Hardingham, Christopher Mark

(57) **Abstract**

A driver circuit for a BMS and method are disclosed, comprising a series arrangement of at least a cell and at least a busbar, and comprising: a first and second voltage rail having a respective first and second terminals for connection to ends of one of the busbar and the cell; a power supply voltage rail, configured to operate at a voltage which is higher than the second voltage rail; a determination circuit, for detecting a lower of supply, LOS, being the one of the first and second voltage rail which is at a lower voltage, and drawing a first bias current from the power supply draw to the LOS; further analog circuit blocks drawing a second bias current from the power supply rail to the LOS; and a current sink circuit arrangement drawing the sum of the first and second bias currents, from the LOS to a ground.

## Description

### Field

The present disclosure relates to battery management systems (BMS) and in particular to circuits and integrated circuits for use in BMS, together with associated methods.

### Background

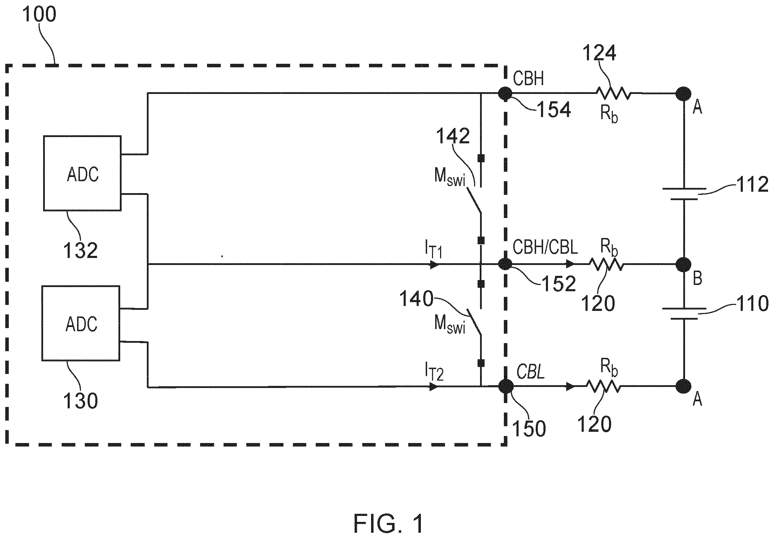

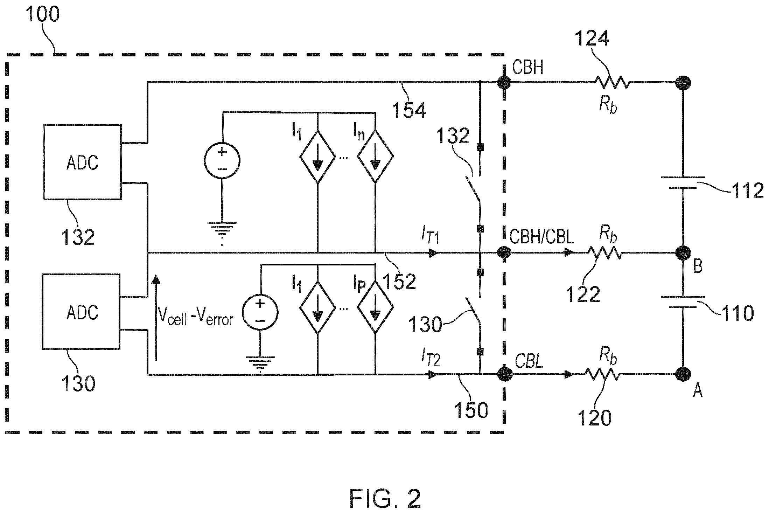

The background to the present disclosure may be well understood with reference to FIG. 1 and FIG. 2. FIG. 1 shows, schematically, part of a BMS IC 100 together with two cells, 110 and 112 under the management of the BMS. The cells are part of a multi-cell battery. The FIG. also shows three resistors 120, 122 and 124 each having nominally the same resistance Rb, for use in balancing the cells, as will be familiar to the skilled person. A principal function of the BMS is to determine the voltages across each of the cells, 110 and 112 in this case, for example by converting the voltage to a digital value using respective analogue to digital converters (ADCs) 130 and 132, and then to balance, or equalise, the voltage across each of the cells. As will be familiar to the skilled person, this may be done by drawing a load from one or more of the cells 110 and 112, for instance by closing one or more of the switches Mswi 140, 142, to draw a current through the balance resistors Rb 120 and 122, or 122 and 124, respectively. In an ideal case, when the balancing switches Mswi are open, there is no current in or out of the IC at pins CBL on voltage rail 150, CBH/CBL on voltage rail 152, and CBH on voltage rail 154. That is to say, I_{T1} = I_{T2} = 0. And, since there is no resulting current through the balancing resistors Rb 120, 122 and 124, there is no voltage drop thereacross, and the voltage at the IC pins on the voltage rails 150, 152 and 154 accurately reflects the voltage at the terminals of the cells 110 and 112.

However, as is shown schematically in FIG. 2, in general neither I_{T1} nor I_{T1} are equal to 0. In particular, due to the presence of various circuitry within the IC which require a bias current to operate, one or more bias currents I₁ ... Iₚ may be either sourced to (as shown) or sinked, also referred to as sunk, from the pin CBL on voltage rail 150. In sum, these currents amount to a current I_{T2} which is sourced from pin CBL on voltage rail 150. This current results in a voltage drop (I_{T2}.Rb) across balancing resistor 120, and the voltage on the IC pin on voltage rail 150 no longer directly corresponds to the voltage at node A. Similarly, one or more currents I₁ ... Iₙ may be either sourced to (as shown) or sunk from the pin CBH/CBL on voltage rail 152. In some, these currents amount to a current I_{T1} which is sourced to pin CBH/CBL on voltage rail 152. This current results in a voltage drop (I_{T1}.Rb) across balancing resistor 122, and the voltage on the IC pin on voltage rail 152 no longer directly corresponds to the voltage at node B. Although, in the case that the currents I_{T1} and I_{T2} are equal, they would cancel at the ADC 130, in general they may not be equal, which results in a voltage offset Verror between cell voltage (Vb-Va) and the ADC input voltage , (Vadc_in). The effect of this error may be significant even with only a few tens of microamps of current consumption in the IC, since the measurement accuracy typically is required to be maintained at or below 1 mV for a BMS.

### Summary

According to a first aspect of the present disclosure, there is provided A driver circuit (410) for a battery management system, BMS, comprising a series arrangement of at least a cell (432) and at least a busbar (442), the driver circuit comprising: a first voltage rail (154) having a first terminal for connection to a first end of one of the busbar and the cell; a second voltage rail (152) having a second terminal for connection to a second end of the one of the busbar and the cell; a power supply voltage rail (552), configured to operate at a voltage which is higher than the second voltage rail; a determination circuit (530), configured to detect, in use, a which of the first and second voltage rail is a lower of supply, LOS, being the one of the first and second voltage rail which is at a lower voltage, wherein the determination circuit draws a first bias current from the power supply to the LOS; an arrangement (540) of one or more further analog circuit blocks, the arrangement drawing a second bias current from the power supply voltage rail to the LOS; and a current sink circuit arrangement configured to draw a third current, equal to the sum of the first and second bias currents, from the LOS to a ground. By providing a current sink circuit arrangement which draws the third current from whichever of the first and second voltage rails is the LOS, to the ground, the current in the voltage rail which is the LOS may be reduced or even eliminated. As a results voltage offsets arising from ohmic losses in or along voltage rail, or through the respective balance resistor may be reduced or even eliminated.

According to one or more embodiments, the current sink circuit arrangement comprises a first current path configured to draw a current equal to the third current between the power supply voltage rail and the ground.

According to one or more such embodiments the current sink circuit arrangement may comprise a first current mirror configured to copy the current equal to the third current to a first grounding current path between the LOS and the ground. The first current mirror may include a selectable first branch between the first voltage rail and ground, and a selectable second branch between the first voltage rail and ground, wherein the driver circuit is configured to select the one of the first branch and the second branch which is the LOS. The first and second current mirrors may each comprise a pair of NMOSEFTs. The first and second switches may each comprise a PMOSFET.

According to one or more other embodiments the current sink circuit arrangement may comprise a selectable first current path (512) and a selectable second current path (514), each configured to selectably draw a current equal to the third current between the power supply voltage rail and the ground. By providing independent and separate current paths, the bias currents may be more effectively neutralised compensated depending on which voltage rail is the LOS.

The driver circuit may further comprise first (M4, M5) and second (M7, M8) current mirrors, configured to copy a current through the respective first and second current paths, through respectively a first grounding current path between the first voltage rail and ground, and a second grounding current path between the second voltage rail and ground.

According to one or more embodiments driver circuit is configured to select the first current path in response to the first voltage rail being the LOS and to select the second current path in response to the second voltage rail being the LOS.

In one or more embodiments the determination circuit comprises a comparator circuit (592) configured to detect, in use, a which of the first and second voltage rail is a lower of supply, LOS, and to enable a first output in response to the first voltage rail being the LOS, and a second output in response to the second output being the LOS;

In one or more embodiments the first output is connected to select the first branch, and the second output is connected to select the second branch. In one or more other embodiments the first output is connected to select the first branch or current path (512), and the second output is connected to select the second current path (514). The first output may be connected to a first switch to select the first current path, and the second output may be connected to a second switch to select the second current path.

According to a second aspect of the present disclosure, there is provided method of operating a driver circuit for a battery management system, wherein the driver circuit comprises a determination circuit configured to detect a which of a first and a second voltage rail is a lower of supply, LOS, being the one of the first and second voltage rail which is at a lower voltage, and an arrangement of one or more further analog circuit blocks, the method comprising: drawing, through the determination circuit, a first bias current from a power supply voltage rail to the LOS; drawing, through the arrangement of one or more further analog circuit blocks, a second bias current from the power supply rail to the LOS; and drawing a third current, equal to the sum of the first and second bias currents, from the LOS to a ground.

According to one or more embodiments drawing the third current from the LOS to a ground comprising drawing a current equal to the third current from a power supply voltage rail to the ground and copying, by a current mirror, the current equal to the third current in a current path between the LOS and the ground.

In to one or more embodiments copying, by a current mirror, the current equal to the third current in a current path between the LOS and the ground comprises selecting a one of a first and a second current path between the power supply voltage rail to the ground and copying, by a current mirror comprised in the selected one of the first and second current path, the current equal to the third current in a current path between the LOS and the ground.

According to one or more embodiments the current mirror comprises a first arm connected in series with a current source, between the power supply voltage rail to the ground, and first and second selectable second arms each forming a current path between the respective first and second voltage rail and the ground, the method comprising selecting the one corresponding to the LOS.

According to a third aspect of the present disclosure, there is provided a battery management system, BMS, driver circuit comprising: first and second pins, the first pin configured to be connected, via a first resistor, to a one of a first terminal of a cell of the battery and a busbar, the second pin configured to be connected, via a second resistor, to a respective one of a second terminal of the cell of the battery and the busbar; a first circuit configured to consume a first bias current (Ip); a determination circuit, configured to, in use, consume a second bias current (I1) and to determine which of the first and second pins is a lower of supply, LOS, pin being a pin is at a lower voltage, a first copy circuit configured to provide a copy current (IT1) being a sum of the first current and the second current; and a current mirror circuit arrangement configured to sink the copy current from the LOS pin to a ground.

The first copy circuit may comprise a current mirror. The current mirror circuit arrangement may comprise a first selectable current mirror and a second selectable current mirror. The determination circuit may be configured to select the first selectable current mirror in response to the first pin being the LOS, and to select the second selectable current mirror in response to the second pin being the LOS.

The BMS driver circuit may further comprising a first switch in series with and for selecting the first selectable current mirror, and a second switch in series with and for selecting the second selectable current mirror, wherein the determination circuit is configured to close the first switch in response to determining that the first pin is the LOS, and to close the second switch in response to determining that the second pin is the LOS.

These and other aspects of the invention will be apparent from, and elucidated with reference to, the embodiments described hereinafter.

### Brief description of Drawings

Embodiments will be described, by way of example only, with reference to the drawings, in which
FIG. 1 shows, schematically, part of a BMS IC 100 together with two cells, 110 and 112 under the management of the BMS;
FIG. 2 shows the simplified schematic of one along with current sources or current sinks affecting some of the IC pins;
FIG. 3A, FIG. 3B and FIG. 3C show various operating configuration of parts of the battery under a battery management system;
FIG. 4 shows, conceptually, various parts of a driver IC comprising a driver circuit according to one or more embodiments of the present disclosure, and
FIG. 5 shows aspects of the present disclosure according to one or more embodiments, for a single cell, in more detail.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments

### Detailed description of embodiments

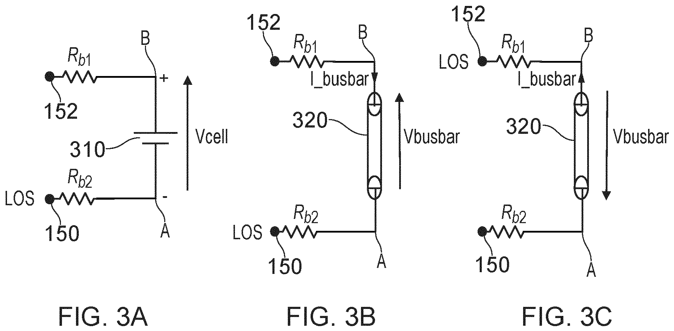

FIG. 3A, FIG. 3B, and FIG. 3C show various operating configuration of parts of the battery, which may be useful for understanding the present disclosure. FIG. 3A shows a single battery cell 310 either from which current is being drawn, or which is being charged. In the case that current is being drawn from the cell, the drawn current may flow through the balance resistors Rb1 and Rb2 to respective pins on voltage rails 150 and 152 of a driver IC (not shown) when cell balancing is activated, or may flow into and through other cells in the battery (not shown). The battery cell has a cell voltage such as 5 V across it, as a result of which node A and the pin on voltage rail 150 (neglecting for the moment, the small losses in the resistor Rb2), re at a voltage 5 V lower than node B. In this configuration, the pin on voltage rail 150 is thus the lower of supply, LOS. In the case that the single cell 310 is being discharged, for instance through the balance resistors Rb1 and Rb2, once again, the cell voltage, of for instance 5 V, results in node A being at a lower voltage than node B, and pin on voltage rail 150 is LOS. Stated different, where there is a cell between node A and node B, node A will always be LOS, since when in presence of a cell voltage (always positive), LOS is always connected to the negative terminal.

Typically, the battery is comprised of several groups, or banks, of stacked cells in which individual cells are connected together as shown in FIG. 2. The negative-most terminal of one bank is typically not adjacent to the positive most terminal of an electrically neighbouring bank. A low resistivity metal bar known as a busbar is used to electrically connect these terminals. Each end of the bar is typically connected to respective node A and B and to a driver circuit pin through a respective resistance, Rb2 and Rb1. FIG. 3B shows an arrangement in which pins on voltage rails 152 and 150 are connected through balancing resistors Rb1 and Rb2 respectively to the nodes B and A at each end of a busbar 320. The FIG. shows the operating configuration in which a current I_busbar is being drawn from a cell connected to node B to a cell connected to a node A, which occurs when the battery is being charged. In this operating configuration, even if the resistance of the busbar is low, it is still finite and non-zero, and so the voltage at node A is less than that at the node B. In a typical situation, the current may be of the order of tens or hundreds of amps, and the resistance may be of the order of mΩ or 10s of mΩ; there results a voltage drop V_busbar across the busbar 320 in a range up to 100s of mV - or even more if the contacts are damaged due to aging. Node A is at a lower voltage than node B and thus pin on voltage rail 150 is LOS. Finally, FIG. 3C shows an operating configuration in which the battery is being discharged, and so the current flow through the busbar is in the opposite direction. In this circumstance, node B is at a lower voltage than node A due to the IR loss in the busbar, and as a result pin on voltage rail 152 is LOS.

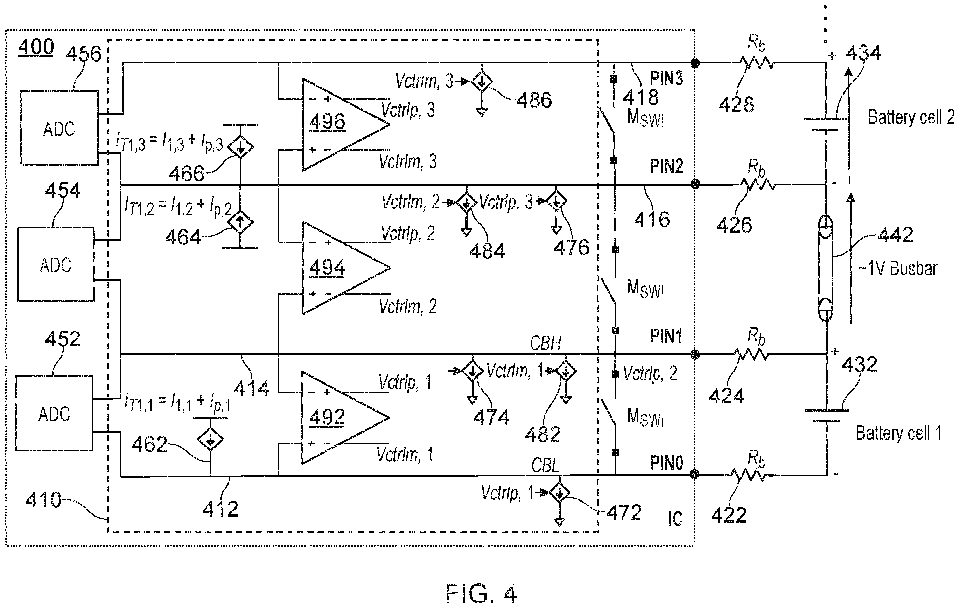

Turning now to FIG. 4, this shows, conceptually, various parts of a driver IC 400 comprising a driver circuit 410 according to one or more embodiments of the present disclosure. The driver IC 400 comprises at least four output pins PIN0 to PIN3, as shown, the output pins are connected through balance resistors Rb 422 424 426 and 428 to respective ends of a first battery cell 432, a busbar 442 and a second battery cell 434. The driver circuit may be described as having voltage rails 412, 414, 416, 418. at the voltages of each of the pins PIN0 to 3 As discussed above, one function of the driver circuit 410 is to measure the voltage across the battery cell 432 and 434, and the busbar 442. In order to do this the pins on voltage rails 412 and 414 are connected to a first ADC 452, pins on voltage rails 414 and 416 are connected to a second ADC 454, and pins on voltage rail 416 and 418 are connected to a third ADC 456. Also as described above, analog circuits which require bias current and form part of the driver IC functionality result in currents being injected or sourced to the various voltage rails.

The currents required by these analog circuit are injected into the lower of the two voltage rails associated with any individual ADC. Thus, as shown at 462, a current (I_{T1,1} = I_{1,1} + I_{p,1}) is injected onto voltage rail 412, being the LOS of the bottom cell balancing driver connected to cell 432, which typically includes ADC 452. Similarly, as shown at 466, a current (I_{T1,3} = I_{1,3} + I_{p,3}) is injected onto voltage rail 416, being lowest of supply for the top cell balancing driver connected to cell 434, which typically includes ADC 456. In the shown configuration, the cells are being discharged, so current is flowing from battery cell 432 to battery cell 434. As a result, the IR drop across busbar 442 means that PIN2 and voltage rail 416 is at a lower voltage than PIN1 and voltage rail 414. That is to say voltage rail 416 is a LOS for the middle cell balancing driver connected to busbar 442, which typically includes ADC 454. The bias and /or other injected currents, (I_{T1,2} = I_{1,2} + I_{p,2}), are, as a result, injected onto voltage rail 416, as shown at 464.

According to embodiments of the present disclosure, the bias currents and/or other currents, that is to say I_{T1,1}, I_{T1,2}, I_{T1,3} which are injected from the power supply voltage rails are removed, by sinking corresponding currents to a ground level. In FIG. 4, this is shown schematically, by the selectable current sinks 472 and 482, 474 and 484, and 476 and 486. Note that for each ADC, there are a pair of selectable current sinks for each ADC (472 and 482 corresponding to ADC 452, 474 and 484 corresponding to ADC 454, and 476 and 486 corresponding to ADC 456). In each case, only one of the current sinks is selected, according to whether the "plus" or "minus" terminal is the lowest of supply (LOS). In the case of battery cell 432, the lowest of supply is determined by a comparator circuit 492, which enables only the one of the outputs Vctrlm,1 and Vctrlp,1 corresponding to the lowest of supply of rails 412 and 414. Selectable current sink 472 is selected according to whether Vctrlp,1 is enabled, and selectable current sink 482 selected according to whether Vctrlm,1 is enabled. As shown, with PIN0 being at a lower voltage than PIN1, it is Vctrlp,1 which is enabled. Similarly, in the case of battery cell 434, the lowest of supply is determined by a comparator circuit 496, which enables the one of the outputs Vctrlm,3 and Vctrlp,3 corresponding to the lowest of supply of rails 416 and 418. Selectable current sink 476 is selected according to whether Vctrlp,3 is enabled, and selectable current sink 486 selected according to whether Vctrlm,3 is enabled. And as shown, with PIN3 being at a lower voltage than PIN2, so Vctrlp,3 is enabled. In the case of busbar 442, the lowest of supply is determined by a comparator circuit 494, which enables the one of the outputs Vctrlm,2 and Vctrlp,2 corresponding to the lowest of supply of rails 414 and 416. Selectable current sink 474 is selected according to whether Vctrlp,2 is enabled, and selectable current sink 484 selected according to whether Vctrlm,2 is enabled. As shown in the FIG., I_{T1,2}, is being injected into voltage rail 416, which is equivalent to saying that voltage rail 416 is the LOS. Thus, in the configuration shown, Vctrlm,2 is enabled, such that current sink 484 is operable and current sink 474 is not operable. By drawing the sum of the current consumptions of the analog blocks that operate across the battery cell from the lowest of supply of the terminals of the cell to ground, current flow to or from the terminals, and thus across the passive cell balancing resistor may be reduced or even eliminated, thereby avoiding any inaccuracies resulting from mismatch of the resistors.

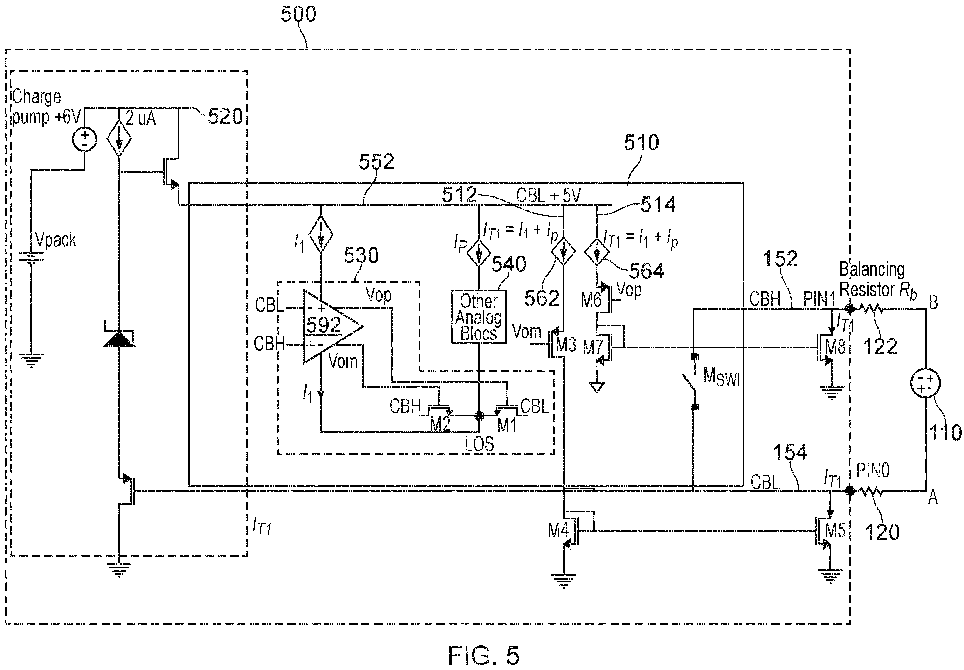

Turning now to FIG. 5, this shows aspects of the present disclosure according to one or more embodiments, for a single cell, in more detail. The FIG. shows a single battery cell 110, having terminals A and B, which are connected to pins PIN0 and PIN1, on first and second voltage rails CBL on voltage rail 154, and CBH on voltage rail 152, of a driver IC 500 through balancing resistors Rb 120 and 122 respectively. The driver IC 500 includes a balance which M_{SWI} between the voltage rail CBL 154 and CBH 152.

The driver IC includes a power supply 520, which may, as shown be based on a charge pump, in order to provide a supply voltage, on a power supply voltage rail 552, which is typically 5V higher than CBL 154. The supply voltage generally should be higher than each of the voltage rails CBL 154 and CBH 152. The power supply voltage rail supplies bias current to one or more analog circuits. In particular, the supply voltage supplies a first bias current I1 to a determination circuit 530. The determination circuit, which may alternatively be referred to as a LOS identifier or a detection circuit, is configured to detect which of the first, CBL and second, CBH voltage rail is a lower of supply, LOS. The bias current flows from the power supply voltage rail through the determination circuit 530 and to LOS of CBL 556 and CBH 558.

The driver IC 500 comprising a driver circuit 510, which includes the determination circuit and an arrangement of one or more further analog circuit blocks, depicted generally as 540 in FIG. 5. Typically, the driver 500 comprises several such drivers, one for each of group of battery cells and bus-bars. The arrangement 540 draws a second bias current Ip from the power supply voltage rail 552 and sinks this bias current Ip onto the LOS of CBL 554 and CBH 552. The skilled person will appreciate that the arrangement may be a single analog circuit having a single bias current Ip, or a plurality of analog circuits the sum of whose bias currents is Ip. An example of such an analog circuit block is a current limiter to protect the pass device switch against over-current.

The driver IC 500 comprising driver circuit 510 includes a current sink circuit arrangement configured to draw a third current, equal to the sum of the first and second bias currents, from the LOS to a ground. Since it is generally not known, a priori, which of CBL 154 and CBH 152 is the LOS, generally the current sink circuit arrangement includes a first selectable current sink (shown as the path including M5) from CBL 154 to ground, shown as M5 in FIG. 5, and a second selectable current sink (shown as the path including M8) from CBH 152 to ground, shown as M8 in FIG. 5. M5 and M8 thus constitute current grounding paths from CBL 154 and CBH 152 respectively. In the embodiment shown in FIG. 5, the current sink M5 between CBL 154 and ground forms part of a current mirror with transistor M4, and the current sink M8 between CBH 152 and ground forms part of a current mirror with transistor M7. The current sink M5 is selectable by a switch M3 which is in series with M4 and between the power supply voltage rail 552 and the ground, in a branch 512. The current through the first branch 512 is set to be (I_{T1,1} = I_{1,1} + I_{p,1}) by current source 562. The current source 562 may be implemented for example using one or more suitably sized MOSFETs arranged in a gate-shorted trans-diode configuration, as will be familiar to the skilled person, sized or chosen to match the bias current source I_{1,1} provided to the determination circuit plus the bias current source or sources I_{p,1} provided to the other analog circuit or circuits. The switch M3 may, as shown, be controlled by a first control signal Vop. Similarly, the current sink M8 is selectable by a switch M6 which is in series with M7 and between the power supply voltage rail 552 and the ground in a second path 514. The current source 564 in this path may similarly be implemented for example using one or more suitably sized MOSFETs arranged in a gate-shorted diode-configuration, sized or chosen, as above. The switch M6 may, as shown, be controlled by a second control signal Vom. The switches M3 and M6 may be implemented as a MOSFET, as shown, or may be implemented as other suitable switching devices as will be familiar to the skilled person. In order to ensure that the devices can be operated within their safe operating area (SOA), it is generally preferred to implement M3 and M6 as PMOSFETs.

The determination circuit 530 may comprise a comparator circuit 592 configured to detect, in use, which of the CBL 154 and CBH 152 is LOS. The circuit may be arranged to enable a first output Vop, in response to CBL 154 being the LOS, and a second output Vom, in response to CBH 152 being the LOS. In addition to controlling which of the first and second branch is enabled in order to determine which of the first and second grounding path is enabled or active, the signals VOP and VOM may be used to control additional switches. For example, as shown in FIG. 5, the signals may be applied to switches M1 and M2 respectively which connects voltage rails CBL 154 and CBH 152 to a LOS node, to which the analog blocks 540 are connected. The determination circuit itself may also be connected to the lowest node, Thus, the bias currents through both of the termination circuit and the arrangement of one or more other analog blocks 540 are directed the one of CBL 100 4054 and CBH 152 which constitutes the LOS.

From reading the present disclosure, other variations and modifications will be apparent to the skilled person. Such variations and modifications may involve equivalent and other features which are already known in the art of battery management systems, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

It is noted that one or more embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Features which are described in the context of separate embodiments may also be provided in combination in a single embodiment. Conversely, various features which are, for brevity, described in the context of a single embodiment, may also be provided separately or in any suitable sub-combination.

For the sake of completeness it is also stated that the term "comprising" does not exclude other elements or steps, the term "a" or "an" does not exclude a plurality, a single processor or other unit may fulfil the functions of several means recited in the claims [delete if not relevant] and reference signs in the claims shall not be construed as limiting the scope of the claims. Furthermore, the word "may" is used in a permissive sense (i.e., meaning having the potential to), rather than the mandatory sense (i.e., meaning must). Similarly, the words "include," "including," and "includes" mean including, but not limited to.

## Claims

1. A driver circuit for a battery management system, BMS, comprising a series arrangement of at least a cell and at least a busbar, the driver circuit comprising:
a first voltage rail having a first terminal for connection to a first end of one of the busbar and the cell;
a second voltage rail having a second terminal for connection to a second end of the one of the busbar and the cell;
a power supply voltage rail, configured to operate at a voltage which is higher than the second voltage rail;
a determination circuit, configured to detect, in use, a which of the first and second voltage rail is a lower of supply, LOS, being the one of the first and second voltage rail which is at a lower voltage, wherein the determination circuit draws a first bias current from the power supply to the LOS;
an arrangement of one or more further analog circuit blocks, the arrangement drawing a second bias current from the power supply voltage rail to the LOS; and
a current sink circuit arrangement configured to draw a third current, equal to the sum of the first and second bias currents, from the LOS to a ground.

2. The driver circuit according to claim 1, wherein the current sink circuit arrangement comprises a selectable first current path and a selectable second current path, each configured to selectably draw a current equal to the third current between the power supply voltage rail and the ground.

3. The driver circuit according to claim 2, further comprising first and second current mirrors, configured to copy a current through the respective first and second current paths, through respectively a first grounding current path between the first voltage rail and ground, and a second grounding current path between the second voltage rail and ground.

4. The driver circuit according to claim 3, wherein the first and second current mirrors each comprise a pair of NMOSEFTs.

5. The driver circuit according to claim 3 or 4, configured to select the first current path in response to the first voltage rail being the LOS and to select the second current path in response to the second voltage rail being the LOS.

6. The driver circuit according to any preceding claim, wherein the determination circuit comprises a comparator circuit configured to detect, in use, a which of the first and second voltage rail is a lower of supply, LOS, and to enable a first output in response to the first voltage rail being the LOS, and a second output in response to the second output being the LOS;

7. The driver circuit according to claim 6 when dependent on claim 2, wherein the first output is connected to select the first current path, and the second output is connected to select the second current path.

8. The driver circuit according to claim 7, wherein the first output is connected to a first switch to select the first current path, and the second output is connected to a second switch to select the second current path.

9. The driver circuit according to claim 8, wherein the first and second switches each comprise a PMOSFET.

10. A method of operating a driver circuit for a battery management system, wherein the driver circuit comprises a determination circuit configured to detect a which of a first and a second voltage rail is a lower of supply, LOS, being the one of the first and second voltage rail which is at a lower voltage, and an arrangement of one or more further analog circuit blocks, the method comprising:
drawing, through the determination circuit, a first bias current from a power supply voltage rail to the LOS;
drawing, through the arrangement of one or more further analog circuit blocks, a second bias current from the power supply voltage rail to the LOS; and
drawing a third current, equal to the sum of the first and second bias currents, from the LOS to a ground.

11. The method of claim 10, wherein copying, by a current mirror, a current equal to the third current in a current path between the LOS and the ground comprises selecting a one of a first and a second current path between the power supply voltage rail to the ground and copying, by a current mirror comprised in the selected one of the first and second current path, the current equal to the third current in a current path between the LOS and the ground.

12. The method of claim 11, wherein the current mirror comprises a first arm connected in series with a current source, between the power supply voltage rail to the ground, and first and second selectable second arms each forming a current path between the respective first and second voltage rail and the ground, the method comprising selecting the one corresponding to the LOS.

## Amended claims

### Amended claims in accordance with Rule 137(2) EPC.

1. A driver circuit (410) for a battery management system, BMS, comprising a series arrangement of at least a cell (432) having a respective cell terminal at each end and at least a busbar (442), the driver circuit comprising:
a first voltage rail (154) having a first terminal for connection to a first end of one of the busbar and the cell;
a second voltage (152) rail having a second terminal for connection to a second end of the one of the busbar and the cell;
a power supply voltage rail (552), configured to operate at a voltage which is higher than the second voltage rail;
a determination circuit (530), configured to detect, in use, a which of the first and second voltage rail is a lower of supply, LOS, being the one of the first and second voltage rail which is at a lower voltage, wherein the determination circuit is configured to draw a first bias current from the power supply voltage rail to the LOS;
an arrangement (540) of one or more further analog circuit blocks, and configured to draw a second bias current from the power supply voltage rail to the LOS; and
a current sink circuit arrangement configured to draw a third current, equal to the sum of the first and second bias currents, from the LOS to a ground.

2. The driver circuit according to claim 1, wherein the current sink circuit arrangement comprises a selectable first current path (512) and a selectable second current path (514), each configured to selectably draw a current equal to the third current between the power supply voltage rail and the ground.

3. The driver circuit according to claim 2, further comprising first (M4, M5) and second (M7, M8) current mirrors, configured to copy a current through the respective first and second current paths, through respectively a first grounding current path between the first voltage rail and ground, and a second grounding current path between the second voltage rail and ground.

4. The driver circuit according to claim 3, wherein the first and second current mirrors each comprise a pair of NMOSFETs.

5. The driver circuit according to claim 3 or 4, configured to select the first current path in response to the first voltage rail being the LOS and to select the second current path in response to the second voltage rail being the LOS.

6. The driver circuit according to any preceding claim, wherein the determination circuit comprises a comparator circuit (592) configured to detect, in use, a which of the first and second voltage rail is a lower of supply, LOS, and to enable a first output in response to the first voltage rail being the LOS, and a second output in response to the second voltage rail being the LOS;

7. The driver circuit according to claim 6 when dependent on claim 2, wherein the first output is connected to select the first current path, and the second output is connected to select the second current path.

8. The driver circuit according to claim 7, further comprising first (M3) and second (M6) switches, wherein the first output is connected to the first switch to select the first current path, and the second output is connected to the second switch to select the second current path.

9. The driver circuit according to claim 8, wherein the first and second switches each comprise a PMOSFET.

10. A method of operating a driver circuit for a battery management system, wherein the driver circuit comprises a determination circuit (530) , and an arrangement of one or more further analog circuit blocks (540), the method comprising:
detecting, by the determination circuit (530), a which of a first and a second voltage rail (152, 154) is a lower of supply, LOS, being the one of the first and second voltage rail which is at a lower voltage;
drawing, through the determination circuit, a first bias current from a power supply voltage rail to the LOS;
drawing, through the arrangement of one or more further analog circuit blocks, a second bias current from the power supply voltage rail to the LOS; and
drawing a third current, equal to the sum of the first and second bias currents, from the LOS to a ground.

11. The method of claim 10, wherein copying, by a current mirror, a current equal to the third current in a current path between the LOS and the ground comprises selecting a one of a first and a second current path between the power supply voltage rail to the ground and copying, by a current mirror comprised in the selected one of the first and second current path, the current equal to the third current in a current path between the LOS and the ground.

12. The method of claim 11, wherein the current mirror comprises a first arm connected in series with a current source, between the power supply voltage rail to the ground, and first and second selectable second arms each forming a current path between the respective first and second voltage rail and the ground, the method comprising selecting the one corresponding to the LOS.
